Europäisches Patentamt

European Patent Office

Office européen des brevets

(19)

(11) Publication number: **0 255 023 B1**

(12) **EUROPEAN PATENT SPECIFICATION**

(45) Date of publication of patent specification: **25.09.91**  (51) Int. Cl.⁵: **C03C 10/08, C04B 35/18**

(21) Application number: **87110543.3**

(22) Date of filing: **21.07.87**

(54) **Zirconia toughening of glass-ceramic materials.**

(30) Priority: **01.08.86 US 892687**

(43) Date of publication of application:
**03.02.88 Bulletin 88/05**

(45) Publication of the grant of the patent:
**25.09.91 Bulletin 91/39**

(84) Designated Contracting States:
**DE FR GB IT**

(56) References cited:
**EP-A- 0 016 307**
**US-A- 3 940 255**
**US-A- 4 225 354**

(73) Proprietor: **International Business Machines
Corporation
Old Orchard Road
Armonk, N.Y. 10504(US)**

(72) Inventor: **Adams, Richard William, Jr.
22 Beacon Street
Congers, N.Y 10920(US)**
Inventor: **Clarke, David Richard
Sunnyridge Road
Katonah, N.Y. 10536(US)**
Inventor: **Rapp, Linda Lenz
17 Wildwood Drive
Poughkeepsie, N.Y. 12603(US)**
Inventor: **Schwartz, Bernard
4 Manor Way
Poughkeepsie, N.Y. 12603(US)**

(74) Representative: **Burt, Roger James, Dr.
IBM United Kingdom Limited Intellectual
Property Department Hursley Park
Winchester Hampshire SO21 2JN(GB)**

## Description

### 1. Field of the Invention

The present invention relates to ceramic packaging materials for large scale integrated electronic circuits and to a process of manufacturing such materials. The toughness (resistance to fracture) of these materials is increased with respect to conventional ceramics.

### 2. Description of Related Art

Zirconia particles toughen a ceramic by either impeding the motion of a propagating crack, or absorbing or dissipating its energy. H. Ruf and A. G. Evans, "Toughening by Monoclinic Zirconia", J. Amer. Cer. Soc., 66(55) 328-332 (1983) and N. Claussen and M. Ruhle, "Design of Transformation-Toughened Ceramics", Advances in Ceramics, Amer. Cer. Soc., (3) 137 (1981). The former includes crack bowing and deflection effects. The latter, termed transformation toughening, results from a stress induced martensitic transformation of the zirconia from its tetragonal crystal structure to its monoclinic crystal structure. This transformation is accompanied by a 4% volume increase and a shear strain up to a maximum of 6%. The attainable toughening is dependent upon the volume fraction of transformable tetragonal phase, size and distribution of the zirconia particles, the elastic constraining properties of the matrix and the size of the transformed zone around the crack. Claussen et al supra; F. F. Lange, "Transformation Toughening", J. Mater. Sci., (17), 235-239 (1982); and A. G. Evans and A. H. Heuer, "Transformation Toughening in Ceramics: Martensitic Transformation in Crack Tip Stress Fields", J. Amer. Cer. Soc., 63 (5-6) 241-248 (1980), and R. McMeeking and A. G. Evans, "Mechanics Of Transformation Toughening In Brittle Materials", J. Amer. Cer. Soc., 65(5) 242-245 (1982).

Zirconia toughening has been demonstrated in a variety of crystalline ceramic materials in the last decade. The earliest example, dating back over ten years, was in a two-phase zirconia ceramic consisting of tetragonal zirconia in a matrix of cubic zirconia. This material, described by R. Garvie, R. H. Hannink and R.T. Pascoe, "Ceramic Steel?", Nature, 258(12) 703-704 (1975) was produced by a precipitation heat treatment. Since this original work, a number of workers have demonstrated that the fracture resistance of many crystalline ceramic materials can be increased by incorporating in them particles of tetragonal zirconia, which transform to the monoclinic form when the material is fractured.

Claussen et al showed that the incorporation of zirconia into an alumina body increased its fracture toughness. Claussen et al. prepared their materials by the usual methods of ceramic forming in which powders of alumina and zirconia were mixed together and then fired to sufficiently high temperatures that the material sintered (densified) to form a monolithic body.

U.S. Patent No. 4,316,964 of Lange et al for "$Al_2O_3/ZrO_2$ Ceramic" describes a zirconia toughened alumina ceramic prepared by using submicron powders of $Al_2O_3$ and $ZrO_2$. "The composite powders were ball-milled with methanol and alumina balls in a plastic container and then dried. Densification was achieved by hot-pressing the powders for 2 hours at a temperature selected to obtain small grain size and therefore favor the retention of tetragonal $ZrO_2$." The pressing temperatures in TABLE I were from 1400 to 1600° C. At Col. 5, line 18 it is stated, "The average grain size of the end member compositions which were hot-pressed at 1400° C was about 2$\mu$m for the $Al_2O_3$ and 0.5ym for the $ZrO_2$." The ceramic is not a glass ceramic and the pressing temperatures employed are excessive from the point of view of the packaging of integrated circuits.

Stevens and Evans, "Transformation Toughening by Dispersed Polycrystalline Zirconia", Br. Ceram. Trans. J. Vol.83, 28-31 (1984) describes transformation toughening of alumina ceramics by volume expansion when tetragonal zirconia transforms to the monoclinic form. It states at page 28, "The phenomenon of transformation toughened ceramics relies on the volume expansion, 3-5%, and shear strain ~7% developed when tetragonal zirconia transforms to the monoclinic form. Toughening of a ceramic host material is attained by retention of the tetragonal zirconia in a metastable state, the phase change to the monoclinic form being initiated by the tensile stress field of an advancing crack. Within a fixed distance of the crack tip, determined by the elastic stress field in its vicinity, any metastable tetragonal zirconia will transform and, as a result of the volume expansion and accommodating shear strains, exerts a back stress on the crack..."

U.S. Patent No. 4,358,516 of Lange, for "Sodium Ion Conductor, Solid Electrolyte Strengthening with Zirconia", describes how the incorporation of transformable tetragonal zirconia could be used to increase the resistance to fracture of a sodium ion conductor solid electrolyte ceramic, $\beta$-alumina. For example, the addition of solid grains of metastable tetragonal $ZrO_2$ with "a grain size less than about 2$\mu$m and has

dissolved it in a rare earth oxide such as $Y_2O_3$..." (See abstract.) The materials are added to the alumina to provide improved fracture toughness.

As in U.S. Patent No. 4,316,964 Lange, one can use additions of rare earth oxides, such as yttria, to control the formation of zirconia that is stable in the finished material in its tetragonal form.

For example, the addition of 15 vol.% zirconia to $\beta''$-$Al_2O_3$ increases the fracture toughness, $K_c$, from 3.0 to 3.8 MPam$^{1/2}$ and the strength from 147 to 414 MPa. See Stevens et al supra. Alumina with 7.5 vol.% zirconia shows an increase in $K_c$ from 4.5 to 7 MPam$^{1/2}$, and adding 17.5 vol.% zirconia to spinel increased the strength from 200 to 500 MPa. (See Claussen et al supra).

Originally used to toughen zirconia ceramics and alumina, the use of transformation toughening has rapidly been accepted as a way of increasing the fracture resistance (toughness) of all sorts of ceramics including oxides, nitrides and carbides. In all these materials, marked increases in toughening have been achieved when the processing conditions have enabled the tetragonal form of zirconia to be retained in the microstructure. However, there is one class of materials in which, despite the incorporation of tetragonal zirconia, true transformation toughening has not been reported, namely glasses and glass-ceramics.

Previous workers, who have attempted to toughen glasses and glass-ceramics by the use of zirconia, have done so by precipitating the zirconia from the glass phase. This is the manner in which zirconia, one of the traditional nucleating aides in the manufacture of glass-ceramics, is known to be formed in its tetragonal form.

For instance, U. S. patent No. 4,396,682 of Mohri et al for "Glazed Ceramic Substrate" describes a ceramic print head with 50-60 Wt.% of $SiO_2$, 10-30 wt.% of CaO and MgO, and 2-6 wt.% of $ZrO_2$ plus optional materials including the addition of one of BaO, ZnO, PbO, $P_2O_5$, $B_2O_3$, $Na_2O$ and $K_2O$. The resulting material is a glass which has excellent high temperature stability for use in thermal print heads. The process used involves the heating in air to 1400° C, which is far above an acceptable level of heating for our process since it would be far above the melting point of the metallization. At Col. 3, lines 6-21 it is explained that the $ZrO_2$ raises the transition point of the glass composition above 2 wt% of $ZrO_2$ in the material. Above 6 wt% the $ZrO_2$ becomes an obstacle to the surface smoothness of the material. No mention is made of the tetragonal phase of the zirconia. In view of the temperature of 1400° C to which the material is heated in the Example, the zirconia is in a solid solution in the glass. Moreover, no mention is made therein of particles of zirconia in the glass.

See also U. S. patent 4,353,047 where zirconia is added as a nucleating agent.

U. S. patent No. 4,234,367 of Herron, Master and Tummala for "Method of Making Multilayered Glass Ceramic Structures Having an Internal Distribution of Copper-based Conductors" describes use of cordierite glass in conjunction with a thermoplastic binder in laminated green sheets. The glass comprises MgO, $Al_2O_3$, $SiO_2$, $B_2O_3$, $SnO_2$, $Al_2O_3$, $P_2O_5$ and $ZrO_2$ glass particles in a glass ceramic. The laminate of green sheets is heated to a burnout temperature of 720 to 785° C. Then the laminate is later heated to a crystallization temperature of about 920 to 970° C. Here the composition of the glass particles is quite different from those employed here in view of the presence of $P_2O_5$, $B_2O_3$ and in some cases $SnO_2$ and the absence of a stabilizing compound such as yttria plus the absence of teachings of particle size limitations claimed herein.

U.S. patent No. 4,225,354 titled "Crystalline Additive for Magnesium Alumina Silicate" discloses a micro-crystalline material and method for making the same wherein a vitreous material known as magnesium aluminum silicate or cordierite glass is caused to undergo a high temperature solid state conversion to a crystalline material and wherein the crystallization is catalyzed by using a nucleating agent on the surface of the base material to trigger microscopic grain formation, the base material that is used being in the form of a fine frit or powder.

U.S. patent No. 3,940,255 titled "Process for making Cordierite Glass-Ceramic having Nucleating Agent and Increased Percent Cordierite Crystallinity" discloses a cordierite-type glass-ceramic and a process for its preparation, characterized in that a nucleating agent in a small amount is added preferably to a glass batch capable of producing cordierite. The nucleating agent aids in forming a glass-ceramic refractory of relatively large amounts of crystalline cordierite. The melt is quenched and ground to an average particle size no greater than about minus 325 U.S. Standard sieve. This particle size in combination with a relatively small amount of a nucleating agent has been found to increase the amount of cordierite formed during crystallization and simultaneously decrease the amount of glassy phase remaining in the glass-ceramic. In this manner, the ultimate product more nearly resembles pure cordierite. The nucleating agent includes the compounds, usually the oxides, of Mo, Ta, Zr, Nb, Ti, Li, As, and mixtures thereof. The preferred nucleating additive or agent is $Nb_2O_5$. The present refractories may have a coefficient of thermal expansion less than $1.60 \times 10^{-6}$ inch/inch/° C from room temperature to about 600° C as determined by the Orton dilatometer.

U.S. patent No. 4,301,324 of Kumar, McMillan and Tummala for "Glass-Ceramic Structures and Sintered Multilayer Substrates with Circuit Patterns of Gold, Silver or Copper" describes β-spodumene glass ceramics and cordierite glass ceramic materials. In connection with the cordierite glass, there is no CaO or $Y_2O_3$ stabilizing material, but there is CAO with respect to the β-spodumene at Col. 7, lines 61 and 62 and in Table I, Col. 4. The cordierite glass does contain from 0 to 2.5 wt % of $ZrO_2$ in Table I. Glass No. 11 in Table III includes $B_2O_3$ plus $ZrO_2$ but also includes $P_2O_5$ and is sintered at 925° C. Glass No. 12 in Table III includes $B_2O_3$ plus $ZrO_2$ but also includes $P_2O_5$ and is sintered at 950° C. There is no suggestion of using yttria as a stabilizing agent. There is also no mention of the tetragonal zirconia phase in connection with Glasses No. 11 and 12. The cordierite is of the μm form for glass No. 11 and of the α form for glass No. 12. See Col. 9, lines 17 to 45. It is stated that the ceramic has greater strength than other ceramics. It is stated that it is thought that the enhanced strength was attributable to inclusion of $ZrO_2$, Col. 9, lines 25 to 28. There is no discussion of the particle sizes of the zirconia. A key distinction of the result of the process of the instant invention from the process of Kumar et al is that the zirconia is in a solid solution in the glass ceramic. We find that there is no encapsulation of particles of zirconia in the tetragonal phase in the Kumar et al product.

U. S. patent No. 4,421,861 of Claussen for "High-Strength and Temperature-Change Resistant Ceramic Formed Body, Especially of Mullite, its Production and Use" describes a zirconia toughened cordierite ceramic made by a reaction process, which involves deriving zirconia from a salt of zirconium. To obtain zirconia in that way the material is sintered at unacceptably high temperatures of from 1300° C, to 1600° C, preferably. Such a high temperature is far higher than an acceptable temperature for formation of VLSI packaging products since it is so high that the copper metallization of the circuits on the package would be destroyed by the heat. In short, the copper would turn to useless puddles on the package. Thus the Claussen et al process is a very significantly different process from the present process. It also produces a much different result.

Ruh et al "Phase Relations in the System $ZrO_2$-$Y_2O_3$ Contents", Communications of American Ceramic Society, C-190 to C-192, (Sep., 1984), describes use of yttria with zirconia to lower the monoclinic-tetragonal transformation temperature of zirconia, but it does not suggest the use of such material with cordierite.

B. Schwartz "Making High Strength Ceramics", IBM Technical Disclosure Bulletin, Vol. 11, No. 7, 848 (Dec. 1968), describes placing the surfaces of a ceramic material in compression relative to the central portions of the article by altering the composition of the outer layers of at least three layers of green ceramic material slightly prior to firing, by adding chromium to alumina. The ceramic materials are used as substrates for microelectronic devices. Obviously this disclosure does not contemplate use of zirconia or the equivalent as the material which provides hardening. In addition it does not suggest the temperature range that is taught here.

In D. J. Green and M. G. Metcalf, "Properties of Slip-Cast Transformation-Toughened β"-$Al_2O_3$/$ZrO_2$ Composites", Ceramic Bulletin, Vol. 63, No. 6 pp. 803-807, and 820 (1984), it is stated at page 805 first full paragraph that "The majority of particles are less than 1&mu.m for both powders but there are some particles as large as 20μm.

Porter, D. L., Evans, A. G., & Heuer, A. H. Acta Metal, Vol. 27, p. 1649 (1979) describe toughening of β"-Alumina and of Zirconia, respectively. None of the prior art suggests the range of sizes of particles of zirconia or hafnia. The temperature range used in forming the hardened ceramic materials is suggested by none of the prior art for forming ceramics and the Herron et al patent 4,234,367 does not relate to hardening of ceramics, but merely to the formation of ceramics, per se.

A number of test methods have been used to measure the fracture toughness of ceramics, and the effect of zirconia additions. One of these is the indentation test method, which is described in detail by Antis et al, "A Critical Evaluation of Indentation Techniques For Measuring Fracture Toughness: I. Direct Crack Measurements", Journal of the American Ceramic Society, 64(9) 533-538, (1981). In this method, a diamond pyramid is pressed, with a known load, into the surface of a material until cracks propagate from the corners of the indentation impression. The length of the cracks so formed for a given load are a measure of the resistance of the material to fracturing (its so-called fracture toughness).

The transformation of zirconia from its tetragonal form to its monoclinic form as a result of the passage of a crack (the basis of transformation toughening) has been shown to lead to an increase in fracture toughness by Garvie et al, "Ceramic Steel ?", Nature, (258), pp. 703-704 (1975) and by Clarke and Adar, "Measurement Of The Crystallographically Transformed Zone Produced By Fracture In Ceramics Containing Tetragonal Zirconia", Journal Of The American Ceramic Society, 65(6) pp. 284-288 (1982). Garvie et al measured their materials before and after fracturing by techniques of X-ray diffraction, to show that some of the tetragonal zirconia had transformed to monoclinic zirconia. Clarke and Adar used Raman spectroscopy to show that some of the zirconia particles around cracks had transformed from the original tetragonal form to the monoclinic form.

The degree of transformation of zirconia from the tetragonal form to the monoclinic form dictates the attainable toughening. Thus, if only 25% of the tetragonal zirconia in a body is transformed to monoclinic zirconia, the fracture toughness will not exceed 25% of that theoretically possible. Likewise, a material made in such a way that part of the zirconia is already in its monoclinic form, there will be less zirconia available in its tetragonal form for transformation to monoclinic.

There is a need to improve the strength of glass-ceramics, such as the cordierite based compositions with the formula shown in TABLE I below.

## TABLE I

| Material | Weight percent |
|---|---|
| $Al_2O_3$ | 21.23 |
| MgO | 20.00 |
| $SiO_2$ | 55.00 |
| $P_2O_5$ | 2.77 |
| $B_2O_3$ | 1.00 |

The material needs to be toughened in order to withstand handling in the electronic circuit manufacturing process.

The object of the invention as claimed is to provide ceramic materials suitable for packaging of electronic circuits and a process of manufacturing such materials at a temperature compatible with the metallization used to provide electrical circuit conductors.

We have found it is critically important that the process be performed at a temperature below the melting or sintering temperature of the metallization such as copper formed on the ceramic material. If the metallization is heated excessively, it melts, disperses, or acts as a flux to the glass or melts to form a puddle on the ceramic material. If the metallization is damaged, the electrical circuits in the integrated circuit structure are destroyed, thereby destroying the value of the package. Previous work in ceramics did not involve such metallization and accordingly process temperatures which were far too high have been employed. It is a prerequisite in the art of electronic circuit packaging that the ceramic materials be processed at lower temperatures compatible with preserving the metallization structures on the packages.

The present invention provides a glass which is transformation toughened through the use of zirconia, which glass is crystallized to a cordierite ($2MgO.2Al_2O_3.5SiO_2$) glass-ceramic upon heat treatment. The method of manufacture, a "composite" route in which particles of the glass, having the desired glass-ceramic composition, and the zirconia are mixed together and fired as in a standard ceramic process. It avoids the conventional glass-ceramic manufacturing route which involve melting of the ingredients, and subsequent crystallization to produce the glass-ceramic body. Furthermore, the method enables the size of the tetragonal particles to be kept within a desirable range.

FIG. 1 shows the X-ray diffraction pattern of 2.2mol% $Y_2O_3$-$ZrO_2$ as received from supplier.

FIG. 2 shows the X-ray diffraction pattern of 10vol%, 2.5mol% $Y_2O_3$-$ZrO_2$ incorporated into the cordierite glass ceramic of TABLE I.

FIG. 3 shows the Fracture Toughness $K_c$ vs Vol% $ZrO_2$ indicating the variation of fracture toughness with the addition of pre-calcined 2.2mol% $Y_2O_3$-$ZrO_2$.

FIG 4 is a graph of the fracture toughness of the glass-ceramic for different values of yttria additions and for different volume additions of zirconia.

FIG. 5 is a sketch based upon a photograph of a Vickers indentation from a 88.236N load in a TABLE I composition of cordierite glass-ceramic containing 10 vol% 2.5mol% $Y_2O_3$-$ZrO_2$.

In FIG. 6, are presented Raman Spectra recorded using an optical probe of a material shown in table III.

Transformation toughening requires a well dispersed phase of metastable tetragonal zirconia, that upon fracturing will transform to the monoclinic form.

Zirconia exists as three phases, monoclinic, tetragonal, and cubic. Monoclinic is the stable form below $950^\circ$ C. The monoclinic to tetragonal transformation occurs between $950^\circ$ C. and $1200^\circ$ C. The cubic phase is formed at 2370°C as explained by R.Stevens, Introduction to Zirconia, Magnesium Elecktron Inc., Flemington, N.J. (1983). Tetragonal zirconia is retained at room temperature through the use of stabilizing oxide compounds such as MgO, CaO and $Y_2O_3$, control of the particle size and the elastic properties of the host matrix. (See Lange, supra and Stevens et al, supra). Adding the stabilizing oxide compounds magnesia (MgO), calcia (CaO) and yttria ($Y_2O_3$), reduces the tetragonal to monoclinic transformation temperature.

We have found that the yttria stabilized zirconia, employed in accordance with this invention, forms the transformable tetragonal phase in the compositional range of 0-5 mol.%. Decreasing the particle size also increases the stability of the tetragonal phase. The maximum particle size at which pure zirconia will remain tetragonal is generally less than 1 $\mu$.m, whereas for a 2 mol.% $Y_2O_3$ stabilized zirconia it is larger. The volume constraining effects of the matrix also increases the stability of the tetragonal form, increasing the critical diameter. (See Lange, supra) Pure zirconia particles less than 0.5$\mu$m in diameter remain tetragonal while constrained in an alumina matrix. The critical diameter in a matrix increases with the use of the partially stabilized zirconias of MgO, CaO and $Y_2O_3$.

Dispersion of zirconia powder in the host matrix is an important processing step of this invention. Agglomerates of zirconia particles contribute flaws to a fired microstructure. Techniques for dispersion included mechanically mixing the powders, attrition of zirconia grinding media, and sol-gel techniques. (Claussen et al, supra). Aside from mechanical mixing, the other processing techniques are expensive and difficult to control. For these reasons, in one aspect of this invention, the mechanical mixing approach is employed in accordance with this invention.

A ceramic material suitable for electronic large scale integrated circuit packaging is composed of a glass ceramic material, preferably a cordierite glass ceramic, of the formula ($2MgO-Al_2O_3-5SiO_2$) encapsulating particles of zirconia, hafnia or some combination of the two such as an alloy thereof. These particles increase in size when they transform from their initial crystal structure to a structure which requires more volume. This increase in volume produces forces which increase the fracture toughness of the material.

We have discovered that it is essential that the zirconia or hafnia particles have a size within the range from about 0.5$\mu$m to about 8.0$\mu$m and preferably about 3.0$\mu$m. It is critically important to the invention, that the particles are so small. When materials are made with significantly larger sizes than the range from about 0.5$\mu$m to about 8.0$\mu$m, no transformation toughening has been obtained during our experiments with the process of this invention.

In addition, we have found it is critically important that the process be performed at a temperature below the melting or sintering temperature of the metallization such as copper formed on the ceramic material. If the copper is heated excessively, it melts, disperses, or acts as a flux to the glass or melts to form a puddle on the ceramic material. If the copper is damaged, the electrical circuits in the integrated circuit structure are destroyed, thereby destroying the value of the package.

In this invention the known additive of a stabilizing oxide compound material such as yttria, magnesia, calcia, titanium dioxide and oxides of rare earths is employed to reduce the tetragonal to monoclinic transformation temperature so that the tetragonal state will be maintained at room temperature.

EXAMPLES

Five zirconia powders have been employed. One was a pure unstabilized zirconia with a mean particle diameter of 0.03$\mu$m and a partially stabilized 2.5 mol.% yttria-zirconia with a mean size of 0.02$\mu$m. The third, a 2.2 mol.% yttria-zirconia with a mean size of 25$\mu$m was employed.

Two 3 mol.% MgO-zirconia powders were investigated, one of which was spray dried. These were prepared from the citrates.

X-ray diffraction studies revealed that the tetragonal content of the partially stabilized powders could be increased by calcining (heating a granular or particulate solid at a temperature below its fusion temperature, but at a temperature sufficient to remove most of its chemically combined volatile matter) to 1180°C. Samples were prepared using both the original powders as received from the manufacturers and powders calcined, as above.

Ball-milling was used to disperse the zirconia powders with the glass powder of the glass ceramic material shown in TABLE I, above.

For compatibility with current techniques for substrate manufacture, methanol, used in the green sheet binder system for MLC structures, is employed as the milling suspension. Methanol produced a superior dispersion of zirconia powders when compared with methyl iso-butyl ketone.

The zirconia powders were milled for one hour prior to adding the powder of the composition shown in TABLE I. Then they were milled an additional 13 hours.

After milling, the powders were further dispersed with a 300 watt ultrasonic probe operated at maximum power for two minutes.

After the ultrasonic mixing step, the methanol solvent was evaporated from the samples while mixing with a magnetic stirrer to prevent preferential particle settling of the denser zirconia particles.

To reduce porosity to a minimum for accurate fracture toughness measurements, one gram green pellets were uniaxially pressed at 88 MPa (Megapascals, where 1 Megapascal = 145 psi), without binder, and then isostatically pressed at 69MPa.

All samples were subsequently air-fired at 960° C for two hours.

The fracture toughness of the samples was measured using the indentation technique after the sample surfaces were ground and polished. See G. R. Anstis, P. Chantikul, B. R. Lawn, and D. B. Marshall, "A Critical Evaluation of Indentation Techniques for Measuring Fracture Toughness: I, Direct Crack Measurements", J. Amer. Cer. Soc. 64 (9) 533-538 (1981); B. H. Mussler and M. W. Shafer, "Preparation and Properties of Mullite-Cordierite Composites", Bull. Amer. Ceram. Soc., 63 (5) 705-710 (1984).

X-ray diffraction revealed that the polished and as fired surfaces were equivalent in tetragonal phase content, assuring test validity. At least three indentations per sample were made with a Zwick (Zwick company, Old Saybrook, Conn.) hardness tester, configured with a Vickers diamond pyramidal indentor. Indentations were done at loads of 29.412 and 88.236 N.

The sonic resonance technique (Schreiber, Anderson and Soga, Elastic Constants and Their Measurements, McGraw-Hill, New York, p. 91 (1974)) was used to measure Young's modulus (required for fracture toughness calculations) for a bar of 10 vol% 2.5 mol% yttria-zirconia and the material of TABLE I, above, air fired to 960° C. This bar was made by the lamination at 31 MPa, of 15 layers of 0.29mm cast green sheets. The green sheet slurry was prepared by using 130% of the binder system employed for casting the powder of TABLE I. Due to the high surface area of the $0.02\mu$m zirconia particles, more binder liquid was needed to lower the slurry viscosity in order to pour it from the ball mill. Dispersion was done in the binder system, first by milling the zirconia powder for one hour and then adding the powder of TABLE I and ball milling for an additional two hours. It should be noted that this method is not effective for complete dispersion and was used only for a Young's modulus specimen.

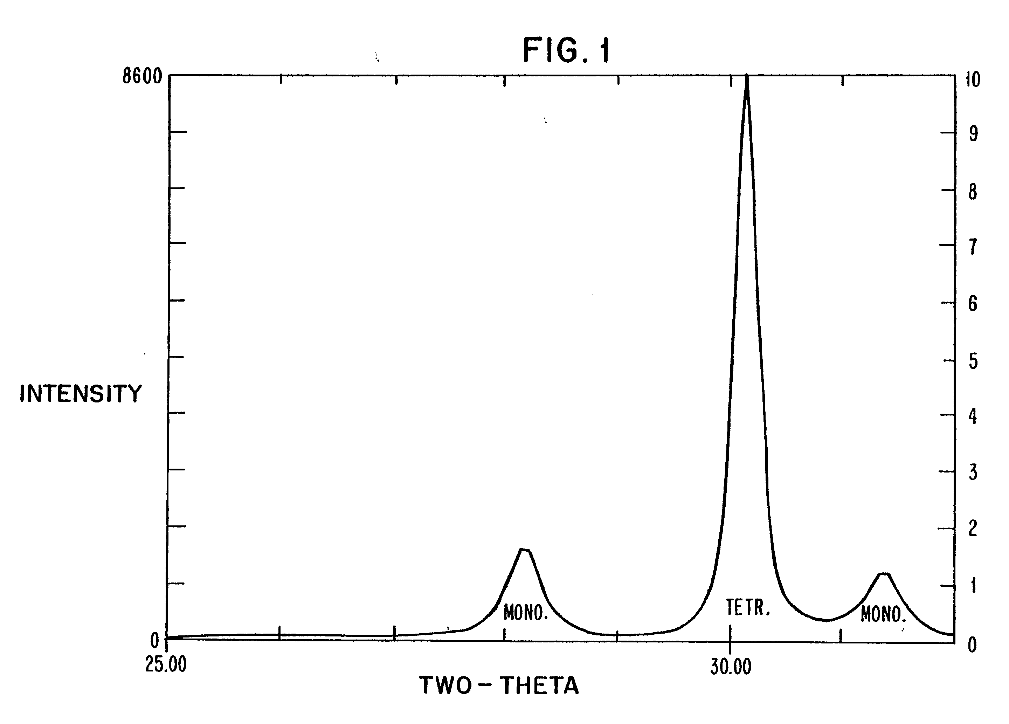

FIG. 1 shows the X-ray diffraction pattern of 2.2mol% $Y_2O_3$-$ZrO_2$ as received from the supplier.

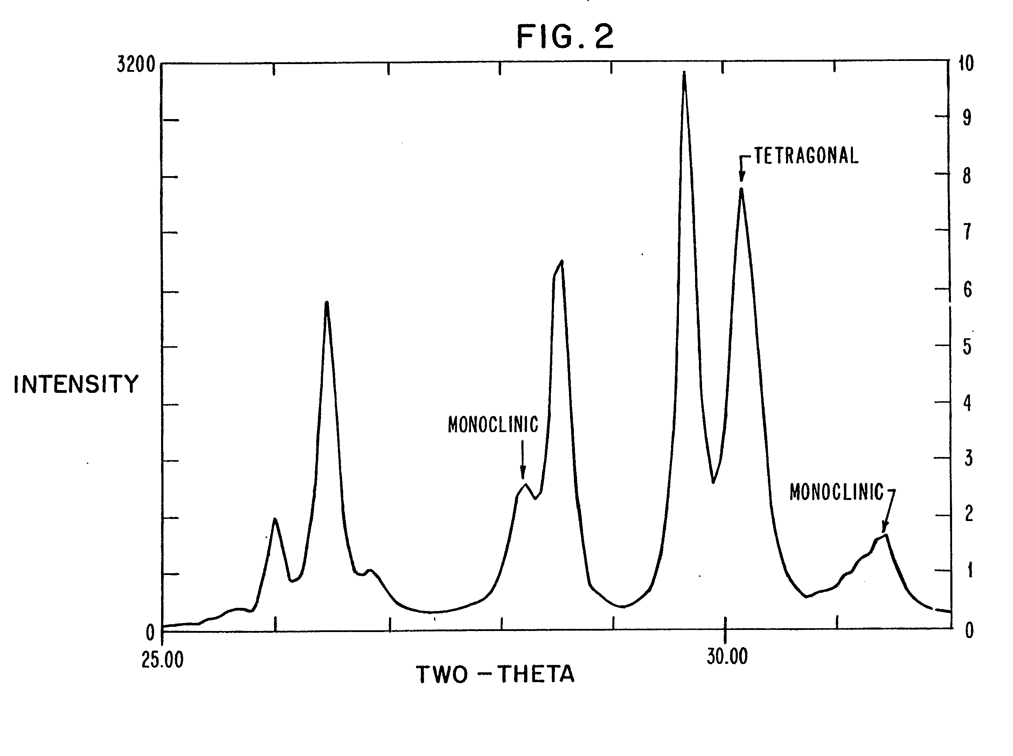

FIG. 2 shows the X-ray diffraction pattern of 10vol% 2.5mol% $Y_2O_3$-$ZrO_2$ incorporated into the cordierite glass ceramic of TABLE I.

X-ray analysis of the powders showed that calcining the commercially manufactured, partially stabilized zirconia to 1180° C could significantly increase the tetragonal phase content. The results, shown in TABLE II below indicate an increase from 50% to 95% tetragonal phase for the pure zirconia of sample 5 in TABLE II and from 73% to 85% for the 2.2mol% yttria-zirconia of sample 9 in TABLE II below. The pure zirconia remained monoclinic.

## TABLE II

### X-RAY DIFFRACTION DATA

VOL% Tetragonal

| SAMPLE | POWDERS | FIRED PELLETS |
|---|---|---|
| 1) MgO-ZrO$_2$ (Sp. dried) | 74% | 10% |
| 2) -Calc.1180°C | -0- | NM* |
| 3) MgO-ZrO$_2$ (Sp. dried) | 42% | -0- |
| 4) -Calc.1180°C | -0- | NM |
| 5) Pure ZrO$_2$ | -0- | -0- |
| 6) -Calc.1180°C | -0- | NM |
| 7) 2.5 mol% Y$_2$O$_3$-ZrO$_2$ | 50 | 58 |
| 8) -Calc.1180°C | 95 | 66 |
| 9) 2.5 mol% Y$_2$O$_3$-ZrO$_2$ | 73 | 58 |
| 10) -Calc.1180°C | 85 | NM |

* NM = Not Measured

Chemically prepared 3 mol% magnesia-zirconia showed a reversal in tetragonal content, becoming completely monoclinic upon calcination. The spray dried powder did show the highest tetragonal content, 74%, of the as-received powders. The magnesia-zirconia system does decompose at 1200°C. An analysis of a sample of this zirconia dispersed in the glass-ceramic and fired to only 960°C shows that the tetragonal content is very low compared to other specimens containing partially stabilized zirconia (TABLE II.) It is possible that various cationic impurities are present in these citrated derived powders that lend stability to the tetragonal phase. Upon firing, these impurities are evolved, decreasing the stability of the tetragonal phase. If the stabilizing oxide compounds along with the impurities could be controlled such that the tetragonal phase begins to lose stability at 960°C, one could incorporate a highly metastable tetragonal zirconia in the glass-ceramic matrix. One would have a zirconia powder that remains highly tetragonal during processing at room temperature, but become highly metastable upon heat treatment to 960°C, maximizing transformation toughening.

The zirconia powders partially transform upon processing. A pre-calcined powder that was 95% tetragonal changed to 74% tetragonal after attritor milling for 30 minutes. The formation of the green pellets

8

by pressing, did not lead to transformation of the zirconia particles.

The fired samples of the commercially manufactured zirconias incorporated in the glass-ceramic do show considerable tetragonal content in an x-ray diffraction pattern, FIG. 2. The tetragonal content calculated for these samples are rough estimates and should not be directly compared with data obtained for zirconia powders.

Additional tests firing the zirconia mixed with the glass of TABLE I revealed that no zircon ($ZrSiO_4$) was formed upon firing the zirconia mixed with the glass of TABLE I even up to temperatures of 1180°C, holding the temperature there for one hour.

Young's modulus for a composite of 10vol% 2.5mol% yttria-zirconia in the material of TABLE I, air fired to 960°C, as determined by sonic resonance was 137GPa. This compares with a Young's modulus of 130GPa for the material of TABLE I alone. The 137GPa value coincides with the calculation of Young's modulus from equations for two phase systems. Young's modulus for 15vol% added zirconia was not measured, but calculated as 141GPa.

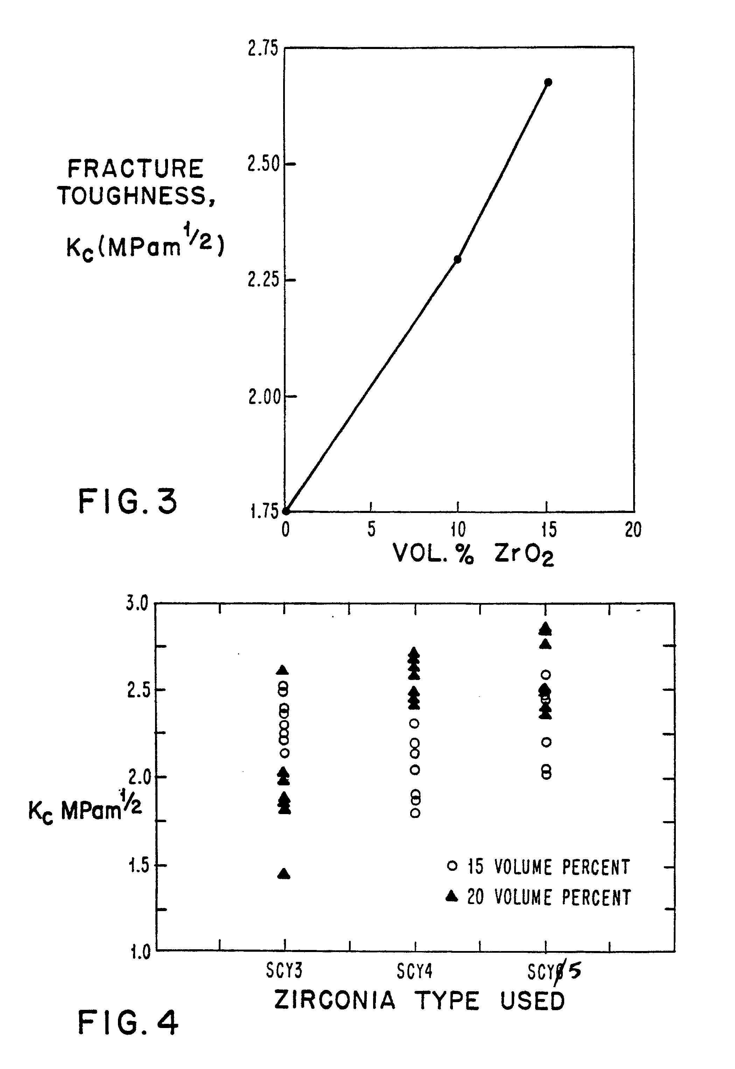

The results of fracture toughness measurements are given in both Table III and in the graph of FIG. 3. FIG. 3 shows the Fracture Toughness $K_c$ vs Vol% $ZrO_2$ indicating the variation of fracture toughness with the addition of pre-calcined 2.2mol% $Y_2O_3$-$ZrO_2$ The maximum error in these measurements is 0,1 $MPam^{1/2}$. The values for fracture toughness, $K_c$, were all measured at the same load, of 88.236N (9 Kg). The graph of FIG. 4. plots the fracture toughness of the glass-ceramic for different values of yttria additions and for different volume additions of zirconia. It plots $K_c$. in $MPam^{1/2}$ vs the Zirconia type used for 15 and 20 percent zirconia with 3, 4 and 5 percent yttria. The variation in measured values of fracture toughness exhibited by the data of FIG. 4 was attributed to variations in dispersion of the zirconia particles and local densification resulting from the presence of agglomerates. The variation thus emphasizes the necessity of good dispersion of the zirconia particles during the material preparation. The increase in fracture toughness of the materials containing zirconia, could be shown to be due to transformation toughening by examining the materials after fracturing.

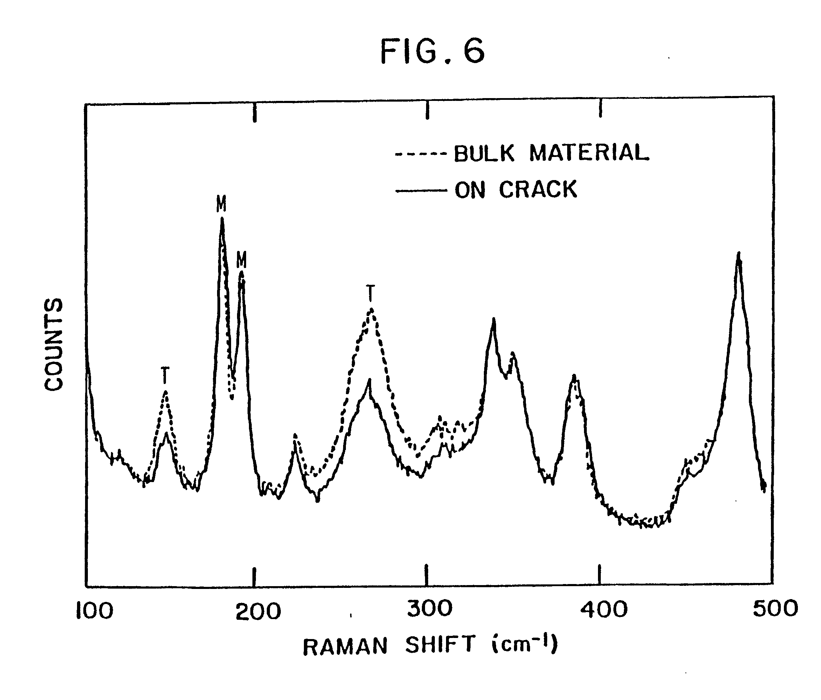

In FIG. 6, are presented Raman Spectra recorded using an optical probe of a material shown in table III. The Raman spectra were recorded on a region remote from indentation crack (top) and from an indentation crack (bottom). The lower ratio of the tetragonal to monoclinic peaks in the bottom spectrum indicates that a fraction of the tetragonal zirconia grains have been transformed by the fracturing process.

## TABLE III

### FRACTURE TOUGHNESS DATA

| SAMPLE | Kc (MPam$^{1/2}$) $\pm$ 0.1 Max | VOL% Tetragonal | %CHANGE |
|---|---|---|---|
| 1) TABLE 1 COMPOSITION | 1.75 | | — |
| 2) 10 vol.% Pure ZrO$_2$ | 2.00 | | + 16 |
| 3) 10 vol.% 2.5mol% Y$_2$O$_3$-ZrO$_2$ | 2.15 | | + 23 |
| 4) -same-precalcined ZrO$_2$ | 2.15 | | + 23 |
| 5) 10 vol% 2.5mol% Y$_2$O$_3$-ZrO$_2$ | 2.43 | | + 39 |
| 6) -same-precalcined ZrO$_2$ | 2.30 | | + 30 |
| 7) 15 vol% 2.2mol% Y$_2$O$_3$-ZrO$_2$ | — | | — |
| 8) -same-precalcined ZrO$_2$ | 2.68 | | + 53 |

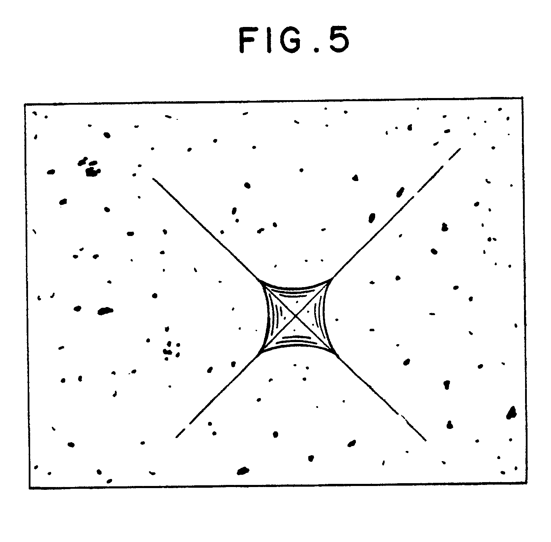

FIG. 5 is a sketch made from a photograph of a Vickers indentation from a 88.236N load in a TABLE I composition of cordierite glass-ceramic containing 10 vol% 2.5mol% Y$_2$O$_3$-ZrO$_2$.

It is important that the zirconia particles be uniformly distributed throughout the matrix. This powder did result in the highest value for fracture toughness, and should contribute the fewest flaws to the fired microstructure.

Adding 10 vol% of the 2.5 mol% yttria-zirconia to the glass-ceramic increased its dielectric constant from 5.0 to 5.8. The value of 5.8 compares with a calculated value of 5.5. The coefficient of thermal expansion increased from $1.8 \times 10^{-6}/^{\circ}$ C for the glass-ceramic alone to $2.5 \times 10^{-6}/^{\circ}$ C at 25 to 300$^{\circ}$ C.

1. Adding a second phase of zirconia particles to the glass-ceramic of TABLE I reduces its brittleness and increases its fracture toughness.

2. Dispersion is very important to the densification and thus the strength of this two phase system. The larger particle size, 25μm powder disperses very well during comminution and mixing in the ball mill and showed the highest fired density of the zirconia plus glass-ceramic mixtures. This powder also resulted in the highest values for fracture toughness: adding 10 vol% increased K$_c$ by 30% to 40%, and adding 15 vol% increased $K_c$ by more than 50%.

3. The 0.02$\mu$m and 0.03$\mu$m powders were too fine to obtain a good dispersion using this process.

In one alternative design, the zirconia or hafnia particles are found only in the outer layer of the material to provide compressive forces there to form an outer compressive layer to resist crack propagation due to the transformation of the zirconia and/or hafnia material to the monoclinic phase from the tetragonal phase, if possible. The incorporation of the zirconia only in the outer layer of the ceramic has the advantage of maintaining a low overall dielectric constant for the ceramic material.

The ceramic material is produced by the process of forming a mixture of a powdered glass ceramic material (which is a glassy precursor of cordierite crystalline ceramic material), formed by the steps which are as follows:

Mix a powdered, tetragonal phase of a material selected from the group consisting of one or more of zirconia or hafnia powder containing a stabilizing oxide compound selected from the group consisting of MgO, CaO, $Y_2O_3$, titania, and selected rare earth oxides, and a glass frit powder or frit of a glassy precursor of a crystalline ceramic material preferably of cordierite composition yielding a suspension of solids.

Disperse the suspended solids to yield a dispersion of the zirconia or hafnia and the glassy precursor.

Densify the dispersion of zirconia or hafnia and glassy precursor by a sintering heat treatment at a temperature of about 840°C to melt the glassy precursor composition into a viscous material at a temperature below the melting point of the zirconia or hafnia powder particles to yield a densified intermediate material with the zirconia or hafnia particles encapsulated in the molten glassy precursor.

Crystallize the densified intermediate material by heating at 900°C. to 950°C.

A process is provided for making the new ceramic material suitable for packaging. It is produced by the process of forming a mixture of a powdered glass ceramic material which is a glassy precursor to the matrix material of the ceramic matrix, formed by the steps which are as follows:

Mix a powdered, tetragonal phase of a material selected from the group consisting of one or more of zirconia or hafnia powder, a stabilizing oxide compound selected from the group consisting of MgO, CaO, $Y_2O_3$, titania, and selected rare earth oxides, and a glass frit powder or frit of a glassy precursor of a crystalline ceramic material preferably of cordierite composition yielding a suspension of solids. The stabilizing oxide compound comprises from 0.1 mole percent to 8 mole percent of the zirconia or hafnia.

Disperse the suspended solids to yield a dispersion of the zirconia or hafnia containing a stabilizing oxide compound, and the cordierite. Densify the dispersion of zirconia or hafnia and cordierite by heat treatment at a temperature of about 840°C to yield a densified intermediate material.

Crystallize the densified intermediate material into a polycrystalline composite by heating at 900°C to 950°C.

In one version of this invention, prior to the step of mixing, one mills the zirconia or hafnia powder in a fluid in a ball mill for one hour to produce ball milled zirconia or hafnia powder. The fluid used to facilitate mixing is methanol. Preferably, the step of ball mixing of the glassy precursor and zirconia or hafnia mixture lasts on the order of 13 hours, and the mixture is mixed during the dispersion step with an ultrasonic probe. Then one dries the product while stirring magnetically or the equivalent.

This invention is applicable in data processing such as personal computers, minicomputers, large scale computers and other data processing equipment. In addition, this system and process will be applicable to industrial and consumer electronic devices employing LSI chips. Electronic products such as transportation and control systems incorporating data processing systems for continuous monitoring and like functions can use the packaging methods and systems of this invention.

## Claims

1. A ceramic material suitable for electronic large scale integrated circuit packaging comprising:

a cordierite glass ceramic material combined in a mixture with particles consisting essentially of a powdered, tetragonal phase of a material selected from the group consisting of one or more of zirconia or hafnia powder, and said mixture containing a stabilizing oxide compound,

said cordierite glass ceramic crystalline material encapsulating said particles and said stabilizing oxide compound,

said stabilizing oxide compound being selected from the group consisting of MgO, CaO and $Y_2O_3$, titania, and rare earth oxides, said stabilizing oxide compound comprising from 0.1 mole percent to 8 mole percent of said zirconia or hafnia,

said stabilizing oxide compound plus said zirconia powder or said hafnia powder comprising at least about 5 weight percent of the total weight percent of said ceramic material and said glass ceramic material comprising at least about 75 volume percent of the total volume of said ceramic material,

said particles having a size within the range from about 0.5μm to about 8.0μm.

2. A process of manufacturing a ceramic material as claimed in Claim 1, wherein a mixture of a powdered glass ceramic material is formed which is a glassy precursor to cordierite crystalline ceramic material, comprising the steps of:

a) mix tetragonal phase material selected from the group consisting of zirconia or hafnia powder containing a stabilizing oxide compound selected from the group consisting of MgO, CaO and $Y_2O_3$ and a glass frit powder or frit of a glassy precursor of cordierite glass ceramic to yield a suspension of solids,

b) disperse the suspended solids to yield a dispersion of said zirconia or hafnia containing said stabilizing oxide compound and said glassy precursor,

c) densify said dispersion of zirconia or hafnia containing said stabilizing oxide compound and said glassy precursor by a sintering heat treatment at a temperature of about 840°C to melt said glassy precursor into a viscous fluid at a temperature below the melting point of said zirconia or hafnia powder particles to yield a densified intermediate material with said zirconia or hafnia particles encapsulated in said molten glassy precursor, and

d) crystallize said densified intermediate material into a polycrystalline composite by heating at 900°C to 950°C,

whereby the yield is a ceramic material consisting of said tetragonal phase material encapsulated in crystalline cordierite glass ceramic material.

3. The process of claim 2, wherein
prior to mixing, the step of milling of said zirconia or hafnia powder in step (a) is performed in a fluid in a ball mill for one hour to produce ball milled zirconia or hafnia powder.

4. The process of claim 3, wherein
said fluid comprises methanol, said methanol being employed to facilitate mixing.

5. The process of claim 3 or 4, wherein
the step of ball mixing of said glassy precursor and said zirconia or hafnia mixture is performed for on the order of 13 hours.

6. The process of claim 5, wherein
said mixture is mixed during the dispersion step with an ultrasonic probe.

7. The process of claim 6, wherein
said mixture is dried while stirring magnetically or the equivalent.

8. The process of claim 2 wherein a binder is included in step (a).

**Revendications**

1. Matériau céramique convenable pour un conditionnement de circuits électroniques à haut niveau d'intégration, caractérisé en ce qu'il comprend :

un matériau verre-céramique de type cordiérite combiné dans un mélange avec des particules consistant essentiellement en une phase tétragonale pulvérulente d'un matériau choisi dans le groupe comprenant un ou plusieurs matériaux parmi une poudre d'oxyde de zircone ou d'oxyde d'hafnium, et ce mélange contenant un composé oxyde stabilisant,

ce matériau cristallin verre-céramique de type cordiérite encapsulant ces particules et ce composé oxyde stabilisant,

ce composé oxyde stabilisant étant choisi dans le groupe comprenant MgO, CaO et $Y_2O_3$, oxyde de titane et oxydes de terres rares, ce composé oxyde stabilisant représentant de 0,1% en moles à 8% en moles de cet oxyde de zirconium ou de cet oxyde d'hafnium,

12

EP 0 255 023 B1

ce composé oxyde stabilisant plus cette poudre d'oxyde de zirconium ou cette poudre d'oxyde d'hafnium constituant au moins environ 5% en poids du pourcentage pondéral total de ce matériau céramique et ce matériau verre-céramique constituant au moins environ 75% en volume du volume total de ce matériau céramique,

ces particules ayant une dimension de l'ordre d'environ 0,5 μm à 8,0 μm.

2. Procédé de fabrication d'un matériau céramique suivant la revendication 1, dans lequel on forme un mélange d'un matériau verre-céramique pulvérulent qui est un précurseur vitreux d'un matériau céramique cristallin de type cordiérite, caractérisé en ce qu'il comprend les étapes suivantes de :

a) mélange d'un matériau en phase tétragonale choisi dans le groupe comprenant une poudre d'oxyde de zirconium ou d'oxyde d'hafnium contenant un composé oxyde stabilisant choisi dans le groupe comprenant MgO, CaO et $Y_2O_3$ et une poudre de fritte de verre ou une fritte d'un précurseur vitreux d'un verre-céramique de type cordiérite pour fournir une suspension de solides,

b) dispersion des solides en suspension pour fournir une dispersion de cet oxyde de zirconium ou de cet oxyde d'hafnium contenant ce composé oxyde stabilisant et ce précurseur vitreux,

c) densification de cette dispersion d'oxyde de zirconium ou d'oxyde d'hafnium contenant ce composé oxyde stabilisant et ce précurseur vitreux par traitement thermique de frittage à une température d'environ 840° C pour faire fondre ce précurseur vitreux en un fluide visqueux à une température inférieure au point de fusion de ces particules d'oxyde de zirconium ou d'oxyde d'hafnium pour fournir un matériau intermédiaire densifié dans lequel ces particules d'oxyde de zirconium ou d'oxyde d'hafnium sont encapsulées dans ce précurseur vitreux fondu, et

d) cristallisation de ce matériau intermédiaire densifié en un matériau composite polycristallin par chauffage à 900-950° C, ce qui fournit un matériau céramique comprenant ce matériau en phase tétragonale encapsulé dans un matériau cristallin verre-céramique de type cordiérite.

3. Procédé suivant la revendication 1, caractérisé en ce qu'avant mélange, l'étape de broyage de cette poudre d'oxyde de zirconium ou d'oxyde d'hafnium dans l'étape (a) est effectuée dans un fluide, dans un broyeur à billes pendant une heure pour produire une poudre d'oxyde de zirconium ou d'oxyde d'hafnium broyée dans un broyeur à billes.

4. Procédé suivant la revendication 3, caractérisé en ce que ce fluide est le méthanol, ce méthanol étant employé pour faciliter le mélange.

5. Procédé suivant la revendication 3 ou la revendication 4, caractérisé en ce que l'étape de broyage dans un broyeur à billes de ce mélange de précurseur vitreux et de cette poudre d'oxyde de zirconium ou d'oxyde d,hafnium, est effectuée pendant environ 13 heures.

6. Procédé suivant la revendication 5, caractérisé en ce que ce mélange est mélangé pendant l'étape de dispersion avec une sonde ultrasonique.

7. Procédé suivant la revendication 6, caractérisé en ce que ce mélange est séché pendant qu'il est agité magnétiquement ou de façon équivalente.

8. Procédé suivant la revendication 2, caractérisé en ce qu'un liant est inclus dans l'étape (a).

**Patentansprüche**

1. Keramisches Material, das zum Kapseln elektronischer LSI-Schaltungen geeignet ist, aus

einem Cordierit-Glaskeramik-Material, das in einem Gemisch mit Teilchen kombiniert ist, die im wesentlichen aus einer pulverisierten tetragonalen Phase eines Materials bestehen, das aus der Gruppe ausgewählt ist, die aus einem oder mehreren Zirkondioxid- oder Hafniumdioxid-Pulvern besteht und wobei das Gemisch eine Stabilisierungsoxidverbindung enthält,

wobei das kristalline Cordierite-Glaskeramik-Material die Teilchen und die Stabilisierungsoxidverbindung einkapselt,

die Stabilisierungsoxidverbindung aus der Gruppe ausgewählt ist, die aus MgO, CaO und $Y_2O_3$,

13

Titandioxiden und Seltenerdoxiden besteht, die Stabilisierungsoxidverbindung von 0,1 Molekularprozent bis 8 Molekularprozente des Zirkondioxids oder Hafniumdioxid aufweist,

die Stabilisierungsoxidverbindung plus das Zirkondioxid-Pulver oder das Hafniumdioxid-Pulver zumindest ungefähr 5 Gewichtsprozente des Gesamtgewichtprozentes des keramischen Materials aufweist und das Glaskeramik-Material zumindest ungefähr 75 Volumsprozente des Gesamtvolumens des keramischen Materials aufweist,

die Teilchen eine Größe innerhalb des Bereiches von ungefähr 0,5 $\mu$m bis ungefähr 8,0 $\mu$m aufweisen.

2. Verfahren zum Herstellen eines keramischen Materials wie in Anspruch 1 beansprucht, bei welchem ein Gemisch eines pulverisierten Glaskeramik-Materials gebildet wird, das ein glasartiger Vorläufer für ein kristallines Cordierit-Keramik-Material ist, welches die folgenden Schritte umfaßt:
   a) Vermischen eines Materials in tetragonaler Phase, das aus der Gruppe ausgewählt ist, die aus einem Zirkondioxid oder Hafniumdioxid-Pulver besteht, das eine Stabilisierungsoxidverbindung enthält, die aus der aus MgO, CaO und $Y_2O_3$ bestehenden Gruppe ausgewählt ist und eines Glasmasse-Pulvers oder einer Glasmasse eines glasartigen Vorläufers einer Cordierit-Glas-Keramik, um eine Suspension fester Körper zu erzeugen,
   b) Dispergieren der suspendierten festen Körper, um eine Dispersion des Zirkondioxids oder des Hafniumdioxids, welches die Stabilisierungsoxidverbindung enthält und des glasartigen Vorläufers zu erzeugen,
   c) Verdichten der Dispersion eines Zirkondioxids oder Hafniumdioxids, welches die Stabilisierungsoxidverbindung enthält und des glasartigen Vorläufers durch eine Sinter-Wärmebehandlung bei einer Temperatur von ungefähr 840°C, um den glasartigen Vorläufer in ein viskoses Fluid bei einer Temperatur unter dem Schmelzpunkt der Zirkondioxid- oder Hafniumdioxid-Pulverteilchen zu schmelzen, um ein verdichtetes Zwischenmaterial zu erzeugen, wobei die Zirkondioxid- oder Hafniumdioxidteilchen in dem geschmolzenen, glasartigen Vorläufer eingekapselt sind und
   d) Kristallisieren des verdichteten Zwischenmaterials in einen polykristallinen Verbundstoff durch Erwärmen bei 900°C bis 950°C,
   wodurch das Erzeugnis ein keramisches Material ist, das aus dem Material in tetragonaler Phase besteht, das in einem kristallinen Cordierite-Glaskeramik-Material eingekapselt ist.

3. Verfahren nach Anspruch 2, bei welchem der Schritt zum Zerkleinern des Zirkondioxid- oder Hafniumdioxid-Pulvers bei dem Schritt a) vor dem Vermischen in einem Fluid in einer Kugelmühle für eine Stunde durchgeführt wird, um ein kugelzerkleinertes Zirkondioxid- oder Hafniumdioxid-Pulver herzustellen.

4. Verfahren nach Anspruch 3, bei welchem das Fluid Methanol aufweist, wobei das Methanol zum Erleichtern des Vermischens verwendet wird.

5. Verfahren nach Anspruch 3 oder 4, bei welchem der Schritt zum Kugel-Vermischen des glasartigen Vorläufers und des Zirkoniumdioxid- oder Hafniumdioxid-Gemisches für in der Größenordnung von 13 Stunden durchgeführt wird.

6. Verfahren nach Anspruch 5, bei welchem das Gemisch während des Schrittes zum Dispergieren mit einer Ultraschallsonde vermischt wird.

7. Verfahren nach Anspruch 6, bei welchem das Gemisch während des magnetischen Rührens oder dazu gleichwertigen getrocknet wird.

8. Verfahren nach Anspruch 2, bei welchem ein Bindemittel in den Schritt (a) einbezogen wird.

# FIG. 1

EP 0 255 023 B1

FIG. 2

FIG. 3

FRACTURE TOUGHNESS, $K_c (MPam^{1/2})$ vs VOL. % $ZrO_2$

FIG. 4

$K_c MPam^{1/2}$ vs ZIRCONIA TYPE USED

○ 15 VOLUME PERCENT
▲ 20 VOLUME PERCENT

# FIG.5

FIG. 6

EP 0 255 023 B1